# EUROPEAN PATENT APPLICATION

(11) **EP 2 343 586 A1**
(43) Date of publication of application: **13.07.2011**
(21) Application number: 09180975.6
(22) Date of filing: 30.12.2009
(51) Int. Cl.: G02B 7/195

(54) **Shape stabilized mirror module and method to stabilize a reflective element.**

(71) Applicant: Nederlandse Organisatie voor Toegepast -Natuurwetenschappelijk Onderzoek TNO, 2628 VK Delft (NL)
(72) Inventor: Lemmen, Martinus Henricus Johannes, 2024 KV Haarlem (NL)
(74) Representative: Hatzmann, Martin

(57) **Abstract**

The invention relates to a mirror module comprising a reflective element, a supporting base element attached to the reflective element, and a heat exchange element for transferring heat to and/or from the mirror module. The mirror module, more in particular the reflective element, is very well stabilized against possible deformation due to a thermal load. The stabilized mirror module is characterised in that it comprises a heat pump, for example a Peltier element, for transferring heat between the reflective element and the heat exchange element, more in particular for cooling the reflective element. The invention also relates to a method to stabilize a mirror module characterised in that a heat flow is measured to stabilise the shape of a reflective element.

## Description

The present invention relates to a mirror module. More in particular it relates to a mirror module comprising a reflective element, a base element attached to the reflective element, and a heat exchange element for transferring heat to and/or from the mirror module.

The present invention further relates to a method for stabilizing the shape of a reflective element. More in particular it relates to a method for stabilizing a reflective element, comprising the sequential steps of measuring the temperature of the reflective element, determining the difference between the measured temperature and a predetermined temperature, and transferring heat to or from the reflective element to compensate for the temperature difference.

### State of the art

Mirror modules are being used in a large variety of optical systems. Mirror modules are being used for projection purposes in for example laser beam projectors and lithographic equipment, and for directing a light beam in for example laser beam scanners. Mirror modules are also being used in astronomic equipment, for example in telescopes for detecting electromagnetic radiation and for earth observation purposes.

The shape stability of mirrors is a constant concern of developers and users of optical systems such as telescopes and projectors. The shape of the mirror determines, among others, the direction and focussing of the reflected beam, the quality of the projected image, and the resolution of a telescope. In particular the temperature variations of the mirror, caused by for example a varying ambient temperature or a varying heat load, are a source of instabilities. Temperature variations result in a variation of the shape of the mirror due to thermal expansion of the materials used to construct the mirror module.

To reduce the temperature variations of mirror modules, such modules are being cooled by for example a cooling liquid, radiation or by thermo-electric elements.

German patent publication DE 3339076 A1 discloses a cooled mirror module. The mirror module comprises channels for a cooling liquid, which cooling liquid allows the transfer of heat away from the mirror module, more in particular away from the reflective element. The heat exchange channels comprise multiple openings spread over the complete area of the reflective element for providing cooling liquid to the backside of the reflective element. This construction allows a rather homogeneous cooling of the reflective element, in particular when the cooling liquid is provided in parallel to all of the openings. The reflective element is attached to a stiff solid base by means of bearing elements. The mechanical connection between the reflective element and the base provides a resistance against thermal deformation and, consequently, deformation of the reflective element. This holds in particular if the reflective element is much thinner than the base. The bearing elements of this known mirror module are thin pipes designed to absorb small differences in the thermal lateral expansion of the base and the reflective element.

A disadvantage of the mirror module known from DE 3339076 A1 is that the cooling method does not allow a very accurate adjustment of the temperature. Another disadvantage is that it is conceptually based on the idea that the complete mirror module has a homogeneous temperature, being the temperature of the cooling liquid. However, instantaneous variations in the heat load might not allow stabilizing the module at that temperature. A temperature gradient in the module, more particular in the reflective element, will cause a deformation of the reflective element that can not be compensated for in this known mirror module. In this known mirror module, the cooling liquid is in direct contact with the reflective element. A disadvantage of such a cooling method is that turbulence and other variations in the liquid flow will result in vibrations of the reflective element. Such vibrations of the reflective element will deteriorate the optical performance of the optical instrument, for instance reduce the resolution of the telescope or the projected optical image.

European patent application EP 1398655 A1 discloses a cooled optical module in which the temperature of the optical elements is regulated by means of a heat pump, more in particular by Peltier elements, situated in between a cooling body and a housing that encloses several optical elements. This known optical module comprises temperature sensors for measuring the temperature at different locations of the module. Based on the measuring signal of the temperature sensors, a controller regulates the heat flow, viz. the cooling and heating capacity, of the Peltier elements that are needed to keep the temperature constant.

A disadvantage of regulating the temperature by means of a heat pump is, that a deformation resulting from stress moment caused by a temperature gradient inside a solid element like the reflective element cannot be compensated for. Because such an element may comprise a block of metal which may be several centimetres thick, it will take some time before the element has a stable temperature, if such a stable situation will be obtained at all, depending, among others, on the heat load stability of the source. Even at a stable temperature, optical element may have a significant axial and radial gradient, which cannot be compensated. During the time that the temperature is not uniform, the reflective element may not have the required shape. For this reason the shape stability of a mirror module comprising no additional means for stabilization will not be sufficient for highly demanding applications like for example semi-conductor lithography at a nanometre scale. Nor will this known mirror module satisfy in high power laser applications with rapidly varying beam intensities.

A well established method, see for example US patent 6,809,888 B1, for stabilizing the shape of a reflective element comprises measuring the temperature of the reflective element, determining the difference between the measured temperature and a predetermined temperature, and transferring heat to or from the reflective element to compensate for the temperature difference. This method is particularly used for cooling the reflective element that is subjected to a heat load, more in particular a varying heat load.

### Summary of the invention

An objective of the present invention is a mirror module comprising a reflective element, the shape of which is hardly susceptible to the thermal load on the reflective element, more in particular to variations and fluctuations in the thermal load, either in time or in place.

The above mentioned objective of the invention is obtained by a mirror module according to the preamble which is characterised by a first heat pump for transferring heat between the reflective element and the heat exchange element.

An advantage of providing a heat pump for transferring heat between the reflective element and the heat exchange element is that the temperature of the reflective element can be adjusted accurately, independent of the actual temperature of the heat exchange element, which heat exchange element might be for instance a channel comprising a cooling medium.

An effect of providing the heat pump is that a well defined or predetermined heat flow can be imposed between the reflective element and the heat exchange element.

The above mentioned objective is obtained with this effect because the heat pump can temporary or locally increase or decrease the heat flow between the reflective element and the heat exchange element, allowing a faster stabilization of the temperature of the reflective element. In contrast to a situation where a passive heat conducting element such as for example a metallic strip or wire is provided for transferring heat between the reflective element and the heat exchange element, the heat transfer can be controlled actively for instance by an electrical signal. The heat flow also might compensate for an inhomogeneous temperature distribution in the mirror module, more in particular in the reflective element.

The mirror module according to the invention is based on the insight that the stability and accuracy of reflective elements can be improved by an interaction of two mechanisms, viz. thermal and mechanical stabilisation. The thermal stabilisation, supported by means of a heat exchange element and a heat pump, has the advantage that this stabilisation is based on the same physical effect as the origin of the disturbance, viz. temperature variations and fluctuations. The mechanical stabilisation, supported by attaching the reflective element to a base element, has the advantage that such a stabilisation corrects for the unwanted consequences, viz. the deformation of the reflective element.

An embodiment of the mirror module according to the invention is characterised by a temperature sensor for measuring a temperature of the reflective element.

An advantage of such a temperature sensor is that the actual temperature of the reflective element can be measured. The sensor can provide a feedback signal to a control unit controlling the heat pump and/or the heat exchange element. This allows a better control of the cooling or heating capacity of the heat exchange element and/or the heat pump than in the case where the control of this capacity is based on for example the heat load or the temperature of the environment.

Another embodiment of the mirror module according to the invention is characterised by a second heat pump for transferring heat between the base element and the heat exchange element.

An advantage of this embodiment is that also the temperature of the base element can be controlled. Stabilisation of the base element will result in a better shape stability of the base element and therefore of the mirror module, more in particular of the reflective element. Especially the first bending mode and the lateral thermal expansion of the mirror can be compensated by this controlled base element.

Another embodiment of the mirror module according to the invention is characterised by a heat flux sensor for measuring the heat flow between the reflective element and the heat exchange element.

An advantage of this embodiment is that additional information is obtained about the thermal load to the reflective element. This information can be used for optimizing the control capacity of the heat pump and/or the heat exchange element.

Another objective of the present invention is providing a method for stabilizing the shape of an reflective element.

The above mentioned objective of the invention is obtained by a method according to the preamble which is characterised in that the method further comprises a step of measuring a heat flow between the reflective element and a heat exchange element, and that the measured heat flow is used for adjusting the heat transfer.

An advantage of using the additional information of the heat flow, which is a measure for the through-thickness thermal gradient in the reflective element, is that the power of the heat pump can be adjusted to the amount of heat that can be transferred under the specific conditions.

An effect of adjusting the amount of heat is that faster heating is possible and that an overshoot in temperature can be prevented. This effect results in a better stabilization of the shape of the mirror module.

### Brief description of the figures

Figure 1 shows schematically a mirror module according to the state of the art.
Figure 2 shows an embodiment of a mirror module according to the invention.
Figure 3 shows an embodiment of a mirror module according to the invention comprising an additional heat pump for transferring heat between the heat exchange element and the base element.
Figure 4 shows a preferred embodiment of a mirror module according to the invention comprising a heat flux sensor for measuring the heat flow between the reflective element and the base element.
Figure 5 shows a schematic representation of the method for stabilizing the shape of a reflective element according to the present invention.

### Detailed description the invention

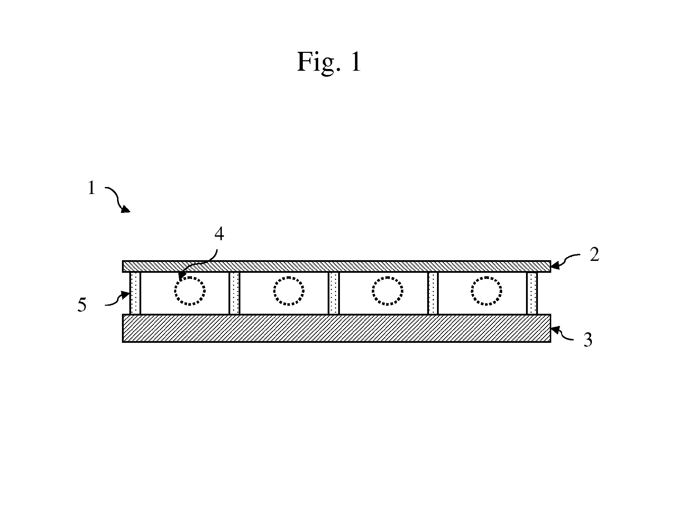

A mirror module (1) according to the state of the art, as shown in figure 1, comprises a reflective element (2), a base element (3) attached, for example by piles (5), to the reflective element (2), and a heat exchange element (4) for transferring heat to and/or from the mirror module. Such a heat exchange element may comprise a channel for cooling liquid as disclosed in German patent publication DE 3339076 A1. The base element (3) counteracts lateral thermal stress in the reflective element and thus prevents, to a certain extent, the reflective element to bend or otherwise deviate from its required shape.

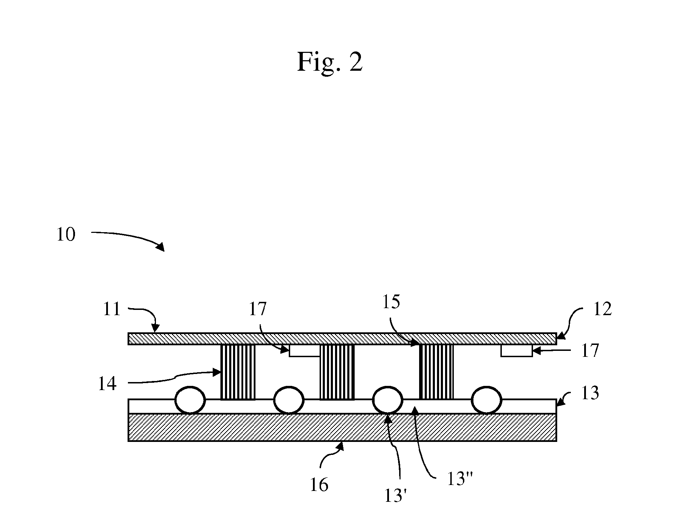

Figure 2 shows an embodiment of a mirror module (10) according to the present invention. The reflective element (12) may be any type of element of which the surface (11) is suitable for reflecting electromagnetic radiation. This electromagnetic radiation may be for example visible, infrared, far infrared, ultra violet, or extreme ultra violet light or it may be x-rays. The reflective element will be constructed out of an appropriate material, which may be a metal like aluminium, copper, titanium, molybdenum, beryllium or nickel/steel. For higher accuracy, low CTE materials (materials with a low coefficient of thermal expansion) may be used, like for example the glass-ceramic Zerodur (trademark of the Schott company), the glass ULE (trademark of the Corning company), carbon fibre reinforced plastic (CFRP), silicon, SiC or SiSiC. The reflective surface (11) may be a polished surface but it may also be a layer that is deposited on a substrate material. It is understood that the reflective element may comprise a protective layer, for example a coating, that is transparent for the electromagnetic radiation. Although the surface of the reflective element is drawn as a flat surface, the surface may have any shape, including parabolic or any suitable freeform.

The mirror module comprises a heat exchange element (13) for transferring heat to and/or from the mirror module. The heat exchange element may for example be a solid element (13") having a good thermal conductivity. It may also comprise cooling channels (13') either in combination with a good conducting solid element or not. In specific situations a heat exchange element comprising fans may satisfy to transfer the heat away from the reflective element. This may be the case in applications where a small temperature load will applied and where the mirror module is placed in air, preferably forced circulated air. However, channels for a cooling gas or even more preferably a cooling liquid may be applied to obtain a large cooling capacity. Although in many application the function of the heat exchange element will be transferring heat away from the reflective element, in other application or under other conditions the heat exchange element may transfer heat to the reflective element.

The module further comprises a heat pump (14) for transferring heat between the reflective element (12) and the heat exchange element (13). This heat pump may be any type of heat pump, including well known refrigeration systems. However, a solid-state heat pump, more in particular a thermo-electric element like a Peltier element is preferred. An advantage of such a solid-state heat pump is that it is compact, without moving parts and that it can be operated electrically allowing easy control by an electrical circuit. In addition, it is an advantage that it can be used both for heating and cooling. By changing the polarity of the voltage applied to the Peltier element, the surface (15) facing the reflective element (12) can either cool or heat the reflective element. The heat exchange element might be constructed as a part of the base (16), for instance as cooling channels in the base. The heat exchange element might also be attached to the base, either with a good thermal contact or thermally isolated. The heat pump might be constructed as being a part of the mechanical connection between the reflective element and the base. However, the mechanical contact between the reflective element and the base may comprise piles, which piles may be simple mechanical piles made, thermopiles or Peltier elements, or other connection means like glue, either additionally or as the sole way of connecting.

The base element (16) may be made out of a block of metal or a low thermal expansion material like Zerodur, molybdenum, tungsten, silicon-carbide or silicon-nitride. Preferably, the base element has a higher stiffness than the reflective element. Because the base element will usually meet less thermal load than the reflective element, the base element will be less subject to thermal expansion or deformation, in particular if cooling channels are situated close to or even in the base element. So, the base element will counteract a deformation force of the reflective layer by providing a compensation force, especially to compensate the first bending mode and the lateral expansion of the reflective element. It will depend on the stiffness and thermal properties of the reflective element, the base element and the connection between these elements to what extent the deformation force will be compensated. However, in any case the deformation of the reflective element will be less than without the base element.

In figure 2 the reflective element is attached to the base element via the heat exchange element (13) and the heat pump (14). However, the reflective element can alternatively or additionally be attached to the base element via supporting piles as shown in figure 1 or by infilling with a proper material, for example a low modulus material like for example silicone, rubber or plastic.

Generally it will be preferred that the heat pump (14) is controlled on the basis of the actual temperature at, in, or near the reflective element in the vicinity of the device. For this purpose the mirror module may comprise one or more temperature sensors (17). However, the device might also be controlled on the basis of heat load, in particular if this load is well known and well defined in place and time. The latter might be the case in applications with a periodic heat load. The signal of the temperature sensor (17) may be used to control the heat flow via the heat pump. The temperature sensor may be a thermocouple, a thermopile or any appropriate sensor for measuring the temperature. A thermocouple or thermopile may be preferred because it can easily be implemented in the electrical circuitry for controlling the temperature of the reflective element. Additional temperature sensors may be situated at other places, for instance at or in the base element or at or in the conduction element.

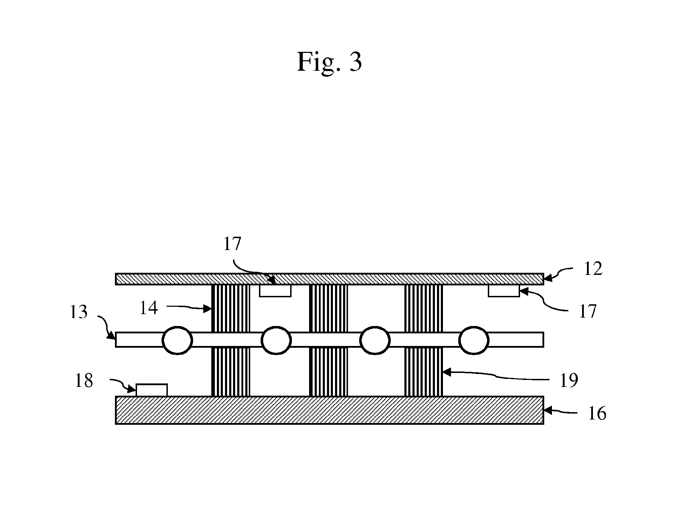

Figure 3 illustrates another embodiment of the mirror module. This embodiment comprises an additional heat pump (19) for transferring heat between the base element (16) and the heat exchange element (13). This heat pump may be of the same type as the heat pump (14) that is situated between the reflective layer (12) and the heat exchange element. Using a thermo-electric element like a Peltier element will be advantageous. Such an element allows easy control by an electrical circuit, either computer controlled or not. A computer control allows a control based on a model description of the thermal and mechanical properties and behaviour of the mirror module. Temperature sensors (17) at different locations near or at the reflective layer may provide signals for controlling the heat flow locally. It may be preferred that the mirror module is essentially symmetric along a plane in between the reflective layer and the compensation element. This embodiment of the mirror module may comprise one or more additional temperature sensors (18), for example for measuring the temperature of the base element (16).

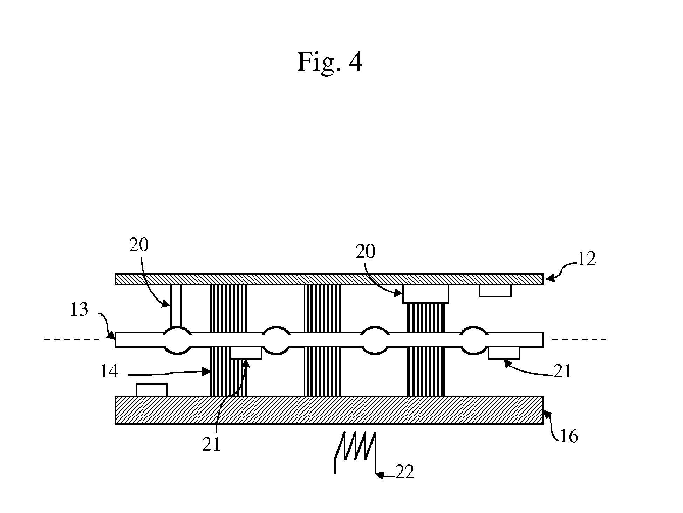

Figure 4 shows a preferred embodiment for a further improved stabilisation, comprising a heat flux sensor (20) for measuring the heat flow between the reflective element (12) and the heat exchange element (13). The heat flow sensor may be a thermopile. This embodiment may also comprise one or more further temperature sensors (21) for measuring the temperature of the heat exchange element (13), more in particular the temperature of a cooling liquid. Measuring the temperature of the cooling liquid allows correction for variations in the temperature of the liquid. Thermopiles allow a good, in particular fast control of the temperature stabilisation, without an overshoot. Thermopiles do not need an external power source, do not cause additional heating and can be integrated as part of an integrated circuit. In specific situations, a heating element (22) can be applied for heating the base element (16). In particular it the thermal load on the reflective element is very high, such a heating might provide additional compensation. The heating element may be a conventional electrical heating element, with or without control. A control might be incorporated in the control of the heat pumps (14, 19). However, the control of the heating element might also be based on a separate temperature or heat load measurement.

The mirror module comprises elements and components with different functionalities. Therefore the module might be constructed out of one or more separate devices and components. However, a large degree of integration or even a complete integration of functionalities might be possible. In particular it is possible to integrate the heat pump, the heat exchange element and/or the temperature sensor in a single semiconductor device. An advantageous embodiment might be one that is composed of two largely integrated parts, which parts are the one above and the one below the dashed line in figure 4. Such parts might be manufactured separately and mounted together by for example gluing.

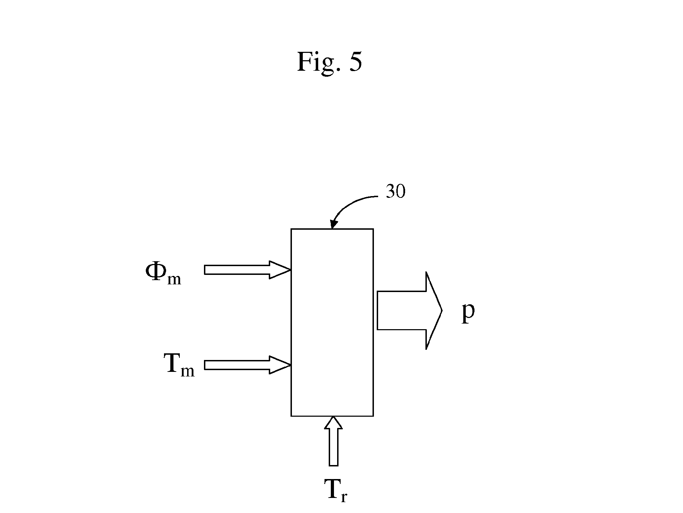

In figure 5, the method for stabilizing the shape of a mirror module is indicated. Both the temperature (Tₘ) of the reflective element and the heat flow (Φₘ) between the reflective element and the heat exchange element are measured. The measurements will preferably be performed with a high frequency to allow a good control. The measured temperature is compared with the required temperature (Tᵣ). A control unit (30), which might be a computer controlled or computer assisted unit, generates a signal (p) for adjusting the heat transfer of a heat pump. In figure 5 only one set of parameters is shown. In practise however, a mirror module may comprise a plurality of temperature sensors, heat pumps and thermopiles to allow a local temperature and deformation control.

Preferably the heat transfer is adjusted with the heat pumps which might be Peltier elements. However, it is also possible the adjust parameters of the heat exchange element, for example the temperature or the flow of a cooling liquid or liquid. The control of the electronic circuit can be based on a feed-forward control principle, using a correlated thermal deformation model of the mirror module. More in particular, a thermal deformation model, relating the shape and the temperature and heat flux at different positions, can be used to calculate the temperature (Tᵣ) that is needed at a specific position to obtain the proper shape of the reflective element of the mirror module.

## Claims

1. Mirror module (10) comprising
- a reflective element (12),
- a base element (16) attached to the reflective element (12), and
- a heat exchange element (13) for transferring heat to and/or from the mirror module,
**characterised by**
- a first heat pump (14) for transferring heat between the reflective element (12) and the heat exchange element (13).

2. Mirror module according to claim 1, further comprising a first temperature sensor (17) for measuring a temperature of the reflective element (12).

3. Mirror module according to claim 1 or 2, further comprising a second heat pump (19) for transferring heat between the base element (16) and the heat exchange element (13).

4. Mirror module according to any of the preceding claims, wherein the first and/or second heat pump (14, 19) is a thermo-electric element.

5. Mirror module according to any of the preceding claims, wherein the heat exchange element (13) is a channel for a liquid or a gas.

6. Mirror module according to any of the preceding claims, wherein the module comprises a second temperature sensor (18) for measuring the temperature of the base element (16).

7. Mirror module according to any of the preceding claims, wherein the module comprises a second or third temperature sensor (21) for measuring the temperature of the heat exchange element (13).

8. Mirror module according to any of the preceding claims, wherein the module comprises a heat flux sensor (20) for measuring the heat flow between the reflective element (12) and the heat exchange element (13).

9. Mirror module according to any of the preceding claims, wherein the mirror module comprises a heating element (22) for providing a thermal load to the base element (16) at the side opposite to the side facing the reflective element (12).

10. Method for stabilizing the shape of a reflective element, the method comprising the sequential steps of
- measuring the temperature of the reflective element
- determining the difference between the measured temperature and a predetermined temperature, and
- transferring heat to or from the reflective element to compensate for the temperature difference,
**characterised in that**
- the method further comprises a step of measuring a heat flow between the reflective element and a heat exchange element, and that
- the measured heat flow is used for adjusting the heat transfer.
